(19) Europäisches Patentamt

European Patent Office

Office européen des brevets

(11) **EP 0 776 486 B1**

(12) **EUROPÄISCHE PATENTSCHRIFT**

(45) Veröffentlichungstag und Bekanntmachung des Hinweises auf die Patenterteilung:
**03.06.1998 Patentblatt 1998/23**

(21) Anmeldenummer: **95927643.7**

(22) Anmeldetag: **07.08.1995**

(51) Int Cl.$^6$: **G01S 7/288**

(86) Internationale Anmeldenummer:
**PCT/DE95/01037**

(87) Internationale Veröffentlichungsnummer:
**WO 96/05518 (22.02.1996 Gazette 1996/09)**

(54) **RADARSENSOR**

RADAR SENSOR

CAPTEUR RADAR

(84) Benannte Vertragsstaaten:
**DE FR GB**

(30) Priorität: **17.08.1994 DE 4429118**

(43) Veröffentlichungstag der Anmeldung:
**04.06.1997 Patentblatt 1997/23**

(73) Patentinhaber: **SIEMENS AKTIENGESELLSCHAFT**
**80333 München (DE)**

(72) Erfinder: **HEIDE, Patric**
**D-81371 München (DE)**

(56) Entgegenhaltungen:
**EP-A- 0 291 337      EP-A- 0 644 438**

- **IEEE TRANSACTIONS ON AEROSPACE AND ELECTRONIC SYSTEMS, Bd. 20, Nr. 6, November 1984 NEW YORK US, Seiten 821-824, C. M. RADER 'a simple method for sampling in-phase and quadrature components'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Radarsensor zur Bestimmung der Geschwindigkeit und/oder der Bewegungsrichtung eines Objekts und ein Verfahren zum Betrieb eines Radarsensors.

Radarsensoren werden vielfach zur berührungslosen Messung von Objektgeschwindigkeiten und Objektabständen verwendet. Dabei bieten Radarsensoren aufgrund ihrer Robustheit gegenüber Umwelteinflüssen im Vergleich zu optischen und akustischen Sensoren beim Betrieb unter rauhen Einsatzbedingungen entscheidende Vorteile.

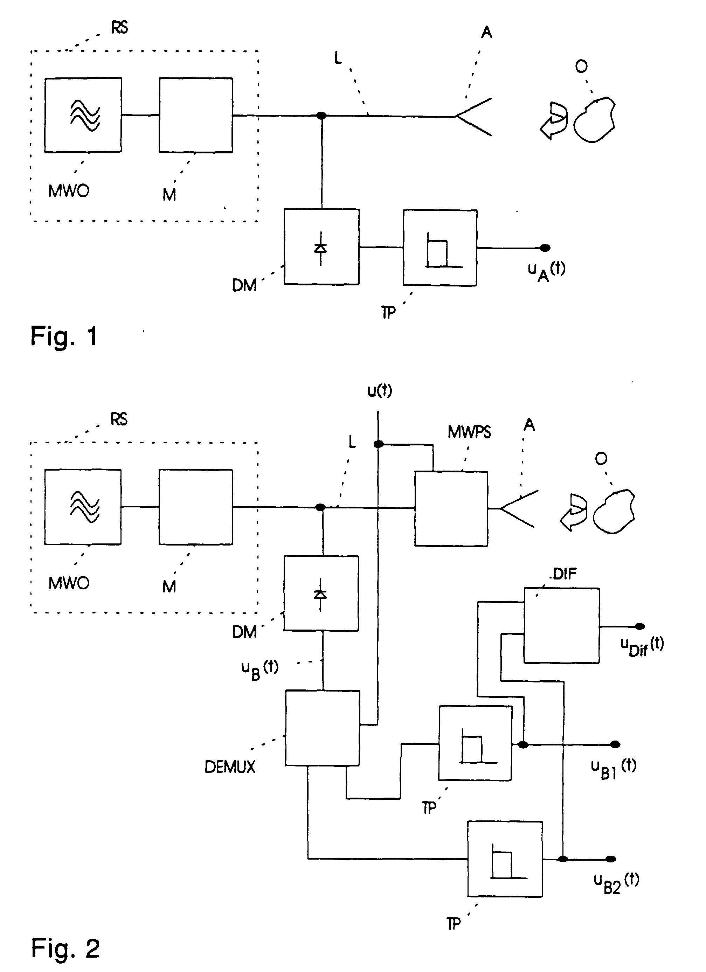

Aus Kostengründen enthalten Radarsensoren oft homodyne Empfänger, d. h. die Demodulation geschieht durch Frequenzmischung des Empfangssignals direkt mit dem Sendesignal. Da in der Praxis die Radarsignalquelle rauscht (z.B. Oszillatorrauschen) ist bereits das Sendesignal verrauscht. Wird in einfachen Radarsensoren als Empfänger, auch genannt Demodulator, ein sogenannter Eindiodenmischer mit nur einer Diode (meist eine Schottkydiode) verwendet, so bewirkt das Rauschen des Sendesignals eine Erhöhung des Empfangsrauschpegels. Fig. 1 zeigt ein dem Stand der Technik entsprechendes Blockschaltbild eines Radarsensors, wie er aus P. Heide, V. Mágori, R. Schubert, R. Schwarte: "24 GHz Low-Cost Doppler Speed-over-Ground with Fundamental-Frequency PHEMT-DRO", IEEE GAAS'94, Turin (Italien), April 1994 bekannt ist. Die Radarsignalquelle RS besteht aus einem Mikrowellenoszillator MWO und enthält meist noch Komponenten zur Modulation M, so daß die Radarsignalquelle RS im allgemeinen ein beliebig moduliertes Radarsignal erzeugt. Die Wahl der Modulation hängt von der Meßaufgabe des Radarsensors ab. Das von der Radarsignalquelle RS erzeugte Signal wird über die Antenne A abgestrahlt und von in der Antennenkeule befindlichen Objekten O als Empfangssignal zurück in die Antenne A reflektiert. Sende- und Empfangssignal, beschrieben durch komplexe Feldstärken $\underline{E}_S$ und $\underline{E}_R$, überlagern sich additiv auf der Leitung L zwischen Radarsignalquelle RS und Antenne A. Der mit der Leitung L verbundene Demodulator DM bewirkt eine homodyne Demodulation und liefert das demodulierte, meist als Dopplersignal bezeichnete, Ausgangssignal $u_A(t)$. Das Tiefpaßfilter (TP) bestimmt die Meßbandbreite des Ausgangssignals. Das Ausgangssignal $u_A(t)$ ergibt sich näherungsweise, als Folge des quadratischen Anteils der Kennlinie der im Demodulator (DM) verwendeten Schottkydiode und nach Tiefpaßfilterung, zu:

$$u_A(t) \sim (\text{Re}\{\underline{E}_S + \underline{E}_R\})^2 = E_S{}^2 + E_R{}^2 + 2E_S E_R \cos(\angle \underline{E}_S \underline{E}_R) \approx E_S{}^2 + 2E_S E_R \cos(\angle \underline{E}_S \underline{E}_R)$$

mit

$\underline{E}_S$ = komplexe Sendefeldstärke (entspricht dem Sendesignal)
$\underline{E}_R$ = komplexe Empfangsfeldstärke (entspricht dem Empfangssignal)
$2E_S E_R \cos(\angle \underline{E}_S \underline{E}_R)$ = Nutzsignal
$E_S{}^2$ = gleichgerichtetes Sendesignal (verrauschtes Störsignal)
$E_R{}^2$ = gleichgerichtetes Empfangssignal
$E_R \ll E_S$ Empfangssignal viel kleiner als Sendesignal

Aufgrund des Rauschens der Radarsignalquelle RS ist die Amplitude des Sendesignals nicht konstant, daher ist auch der Term $E_S{}^2$ verrauscht. $E_S{}^2$ ist daher als Störsignal aufzufassen, welches sich nachteilig durch Verminderung des Signal/Rauschabstandes des Ausgangssignals $u_A(t)$ auswirkt.

In aufwendigeren Radarsensoren wird dieser Nachteil durch Verwendung sogenannter balanzierter Mischer (engl. balanced mixers), die u.a. in dem Buch Stephen A. Maas: "Microwave Mixers", Artech House, Dedham, MA (USA) beschrieben sind, umgangen. Der Radarsensor wird dadurch aber beträchtlich aufwendiger. Zudem liefern auch die Mischer selbst Rauschbeiträge, die durch Verwendung balanzierter Mischer nicht unterdrückt werden.

In der nach Artikel 54(3) EPÜ in Verbindung mit Artikel 89 EPÜ als Stand der Technik geltenden EP 0 644 438 A2 ist ein Radargerät beschrieben, bei dem zwischen der Radarantenne und dem Radarfrontend ein Phasenschieber geschaltet ist, der zur Erzeugung eines IQ-Signalpaares zur Quadraturdemodulation vorgesehen ist. Mittels eines Umschalters wird zwischen zwei Signalkanälen der Auswerteschaltung taktgesteuert synchron mit dem Phasenschieber umgeschaltet. Eine Quadraturdemodulation, wie in J. Detlefsen: "Radartechnik" Seiten 77 ff., Springer Verlag, 1989, beschrieben, ermöglicht es, die Bewegungsrichtung von bewegten Objekten nach Annäherung und Entfernung zu unterscheiden.

Aufgabe der Erfindung ist es, einen Radarsensor anzugeben, bei dem eine Quadraturdemodulation vorgesehen werden kann und bei dem eine wirkungsvolle Rauschunterdrückung erfolgt.

Dies Aufgabe wird mit dem Radarsensor gemäß Anspruch 1 gelöst. Ausgestaltungen ergeben sich aus den abhängigen Ansprüchen.

Erfindungsgemäß bleiben sowohl das Rauschen des Sendesignals (unabhängig von der Modulation des Sendesignals) als auch das Rauschen des Demodulators ohne Einfluß auf die Meßgenauigkeit. Gleichzeitig sind eine Rauschunterdrückung und eine Quadraturdemodulation möglich.

Anhand der Figuren soll die Erfindung näher erläutert werden.

Fig. 1    zeigt den Aufbau eines Radarsensors gemäß dem Stand der Technik P. Heide, V. Mágori, R. Schubert, R. Schwarte: "24 GHz Low-Cost Doppler Speed-over-Ground with Fundamental-Frequency PHEMT-DRO", IEEE GAAS'94, Turin (Italien), April 1994.

Fig. 2    zeigt den erfindungsgemäßen Aufbau eines Radarsensors.

Zusätzlich zu der dem Stand der Technik entsprechenden Anordnung nach Fig. 1 weist die erfindungsgemäße Anordnung nach Fig. 2 einen Mikrowellen-Phasenschieber MWPS, einen Demultiplexer DEMUX, ein Differenzbildungsglied DIF und ein zweites Tiefpaßfilter TP auf.

Von einem, z.B. periodischen TTL-Signal u(t) gesteuert, wird mit Hilfe des Mikrowellen-Phasenschiebers MWPS die Phase des Empfangssignals $\underline{E}_R$ und demzufolge die Phase von $2E_SE_R cos(\angle \underline{E}_S\underline{E}_R)$, was dem Nutzsignal entspricht, zwischen zwei Phasenzuständen der Phasendifferenz $\Delta\varphi$ umgeschaltet. Gleichzeitig wird das demodulierte Ausgangssignal $u_B(t)$ auf zwei den beiden Phasenzuständen entsprechende Ausgangssignale $u_{B1}(t)$, $u_{B2}(t)$ aufgespalten. Die beiden Gleichungen für die Ausgangssignale $u_{B1}(t)$, $u_{B2}(t)$ lauten wie folgt:

$$u_{B1}(t) \approx E_S^2 + 2E_SE_R \cos(\angle \underline{E}_S\underline{E}_R)$$

$$u_{B2}(t) \approx E_S^2 + 2E_SE_R \cos([\angle \underline{E}_S\underline{E}_R] + \Delta\varphi)$$

Wählt man $\Delta\varphi=180°$, so läßt sich ein Differenzsignal $u_{DIF}(t)$ wie folgt bilden:

$$u_{DIF}(t) = u_{B1}(t) - u_{B2}(t) = 4E_SE_R\cos(\angle \underline{E}_S\underline{E}_R)$$

Sowohl der durch das Rauschen der Radarsignalquelle RS verrauschte Störterm $E_S^2$ als auch die Rauschbeiträge des Demodulators DM selbst sind im Differenzsignal $u_{DIF}(t)$ nicht mehr enthalten. Daher besitzt das Differenzsignal $u_{DIF}(t)$ einen erheblich höheren Signal/Rauschabstand als das Signal $u_A(t)$ gemäß Fig. 1.

Das Umschaltsignal u(t) ist beispielsweise ein periodisches Rechtecksignal der Umschaltfrequenz $f_U$. Die Rauschunterdrückung ist dann wirkungsvoll, wenn die Umschaltfrequenz $f_U$ mindestens eine Größenordnung höher als die gewünschte Bandbreite der Ausgangssignale $u_{B1}(t)$, $u_{B2}(t)$ gemäß Fig. 2 ist.

Im Prinzip sind beliebige Signalformen des Umschaltsignals u(t) zulässig, die eine im Vergleich zu den im Rauschen enthaltenen Frequenzen schnelle Umschaltung ermöglichen. Wird die Phasendifferenz $\Delta\varphi$ nicht zu 180°, sondern zu $0<|\Delta\varphi|<180°$ gewählt, so enthalten $u_{B1}(t)$, $u_{B2}(t)$ dann orthogonale Signalanteile oder sind für $\Delta\varphi=\pm90°$ sogar vollständig orthogonal. Demzufolge erlaubt die erfindungsgemäße Anordnung nach Fig. 2 auch eine Quadraturdemodulation. Der Vorteil gegenüber dem Stand der Technik J. Detlefsen: "Radartechnik" Seite 77 ff., Springer Verlag, 1989 liegt darin, daß zur Quadraturdemodulation kein zweiter Demodulator DM benötigt wird.

Eine weitere Weiterbildung der Erfindung ist, die Phasendifferenz $\Delta\varphi$ im Bereich von $0<|\Delta\varphi|<180°$ zu wählen und auch hier die Differenz der Ausgangssignale $u_{B1}(t)$ und $u_{B2}(t)$ $u_{DIF}(t)=u_{B1}(t)-u_{B2}(t)$ zu bilden. Die Anordnung liefert dann drei Ausgangssignale. Das Differenzsignal $u_{DIF}(t)$ ist ein von Rauschen bereinigtes Signal und die Ausgangssignale $u_{B1}(t)$, $u_{B2}(t)$ sind die Quadraturkomponenten zur Erkennung der Objektbewegungsrichtung.

Der Demodulator muß kein Eindiodenmischer sondern kann ein beliebiger Mischer oder ein beliebiges nichtlineares Bauteil sein, mit dem eine Frequenzmischung bewerkstelligt werden kann.

Das Umschaltsignal u(t) kann auch ein nicht periodisches Signal sein.

Als Demultiplexer DEMUX kann unter anderem ein Umschalter verwendet werden oder auch ein Element, das das Demodulatorsignal $u_B(t)$ abtastet, digitalisiert und speichert.

**Patentansprüche**

1.   Radarsensor,

-   bei dem ein Mittel zur Erzeugung eines Radarsignals (RS) mit einem Phasenschieber (MWPS) und einem Demodulator (DM) verbunden ist,
-   bei dem der Phasenschieber (MWPS) mit einer Antenne (A) und mit dem Demodulator (DM) verbunden ist,
-   bei dem ein Demultiplexer (DEMUX) mit zwei Ausgängen dem Demodulator (DM) nachgeschaltet ist,

- bei dem Mittel vorhanden sind, mit denen der Demultiplexer und der Phasenschieber (MWPS) mit einem Umschaltsignal (u(t)) getaktet werden können,
- bei dem die Ausgänge des Demultiplexers (DEMUX) jeweils mit einem Tiefpaß (TP) verbunden sind und
- bei dem den Tiefpässen (TP) ein Differenzbildungsglied (DIF) nachgeschaltet ist, das ein Differenzsignal ($u_{Dif}$(t)) von Ausgangssignalen ($u_{B1}$(t), $u_{B2}$(t)) der Tiefpässe bildet.

2. Radarsensor nach Anspruch 1,

- bei dem das Umschaltsignal (u(t)) periodisch ist und
- bei dem die Frequenz des Umschaltsignals (u(t)) höher als eine gewünschte Bandbreite der Ausgangssignale ($u_{B1}$(t), $u_{B2}$(t)) ist.

3. Radarsensor nach Anspruch 1 oder 2,
bei dem der Phasenschieber (MWPS) ein dem Demodulator zugeleitetes Signal zwischen Phasenzuständen einer Phasendifferenz $\Delta\varphi$ von 180° umschaltet.

4. Radarsensor nach Anspruch 1 oder 2,
bei dem der Phasenschieber (MWPS) ein dem Demodulator zugeleitetes Signal zwischen Phasenzuständen einer Phasendifferenz $\Delta\varphi$ in dem Bereich von $0<|\Delta\varphi|<180°$ umschaltet.

5. Radarsensor nach Anspruch 4,
bei dem der Phasenschieber (MWPS) ein dem Demodulator zugeleitetes Signal zwischen Phasenzuständen einer Phasendifferenz $\Delta\varphi$ von $\pm$ 90° umschaltet.

**Claims**

1. Radar sensor,

- in which a means for producing a radar signal (RS) is connected to a phase shifter (MWPS) and to a demodulator (DM),
- in which the phase shifter (MWPS) is connected to an antenna (A) and to the demodulator (DM),
- in which a demultiplexer (DEMUX) having two outputs is connected downstream of the demodulator (DM),
- in which there are means with which the demultiplexer and the phase shifter (MWPS) can be clocked with a changeover signal (u(t)),
- in which the outputs of the demultiplexer (DEMUX) are each connected to a low-pass filter (TP), and
- in which a substraction element (DIF) is connected downstream of the low-pass filters (TP) and forms a difference signal ($u_{Dif}$(t)) from the output signals ($u_{B1}$(t), $u_{B2}$(t)) of the low-pass filters.

2. Radar sensor as claimed in Claim 1,

- in which the changeover signal (u(t)) is periodic, and
- in which the frequency of the changeover signal (u(t)) is higher than the desired bandwidth of the output signals ($u_{B1}$(t), $u_{B2}$(t)).

3. Radar sensor according to Claim 1 or 2,
in which the phase shifter (MWPS) switches a signal, which is supplied to the demodulator, between phase states having a phase difference $\Delta\phi$ of 180°.

4. Radar sensor according to Claim 1 or 2,
in which the phase shifter (MWPS) switches a signal which is supplied to the demodulator, between phase states having a phase difference $\Delta\phi$ in the range $0<|\Delta\phi|<180°$.

5. Radar sensor according to Claim 4, in which the phase shifter (MWPS) switches a signal, which is supplied to the demodulator, between phase states having a phase difference $\Delta\phi$ of $\pm$ 90°.

**Revendications**

1. Capteur radar,

   - dans lequel un moyen pour la production d'un signal radar (RS) est relié avec un réseau déphaseur (MWPS) et un démodulateur (DM),
   - dans lequel le réseau déphaseur (MWPS) est relié avec une antenne (A) et avec le démodulateur (DM),
   - dans lequel un démultiplexeur (DEMUX) avec deux sorties est intercalé à la suite du démodulateur (DM),
   - dans lequel des moyens sont disponibles, avec lesquels le démultiplexeur et le réseau déphaseur (MWPS) peuvent être synchronisés avec un signal de commutation (u(t)),
   - dans lequel les sorties du démultiplexeur (DEMUX) sont à chaque fois reliées avec un filtre passe bas (TP) et
   - dans lequel un élément de formation de la différence (DIF) est intercalé à la suite des filtres passe bas (TP), ledit élément formant un signal différentiel ($u_{DIF}(t)$) à partir des signaux de sortie ($u_{B1}(t)$, $u_{B2}(t)$) des filtres passe bas.

2. Capteur radar selon la revendication 1,

   - dans lequel le signal de commutation (u(t)) est périodique et
   - dans lequel la fréquence du signal de commutation (u(t)) est plus élevée qu'une largeur de bande souhaitée des signaux de sortie ($u_{B1}(t)$, $u_{B2}(t)$).

3. Capteur radar selon la revendication 1 ou 2, dans lequel le réseau déphaseur (MWPS) commute un signal amené au démodulateur entre des états de phase d'une différence de phase $\Delta\varphi$ de 180°.

4. Capteur radar selon la revendication 1 ou 2, dans lequel le réseau déphaseur (MWPS) commute un signal amené au démodulateur entre des états de phase d'une différence de phase dans le domaine de $0<|\Delta\varphi|<180°$.

5. Capteur radar selon la revendication 4, dans lequel le réseau déphaseur (MWPS) commute un signal amené au démodulateur entre des états de phase d'une différence de phase $\Delta\varphi$ de $\pm90°$.

RS

MWO    M    L    A    O

DM    TP    $u_A(t)$

## Fig. 1

$u(t)$

RS

MWO    M    L    MWPS    A    O

DM

$u_B(t)$

DEMUX    .DIF    $u_{Dif}(t)$

TP    $u_{B1}(t)$

TP    $u_{B2}(t)$

## Fig. 2